# EUROPEAN PATENT SPECIFICATION

(11) **EP 1 820 378 B1**
(45) Date of publication and mention of the grant of the patent: **18.09.2013**
(21) Application number: 05851699.8
(22) Date of filing: 14.11.2005
(51) Int. Cl.: H05K 1/02

(54) **COMMUNICATIONS JACK WITH PRINTED WIRING BOARD HAVING PAIRED COUPLING CONDUCTORS**
KOMMUNIKATIONSBUCHSE MIT LEITERPLATTE MIT GEPAARTEN KOPPLUNGSLEITERN
PRISE DE TELECOMMUNICATION AVEC CARTE IMPRIMEE A CONDUCTEURS DE COUPLAGE EN PAIRE

(30) Priority: 07.12.2004 US 633783 P; 16.12.2004 US 636590 P; 16.12.2004 US 636595 P; 28.01.2005 US 648002 P; 04.02.2005 US 51285; 20.09.2005 US 231175
(43) Date of publication of application: 22.08.2007
(60) Divisional application: 12181575.7
(73) Proprietor: COMMSCOPE INC. OF NORTH CAROLINA, Hickory, North Carolina 28601 (US)
(72) Inventor: HASHIM, Amid, Plano, Texas 75093 (US); MOFFITT, Bryan, Red Bank, New Jersey 07701 (US); PHARNEY, Julian, Indianapolis, Indiana 46236 (US)
(74) Representative: Popp, Eugen
(86) International application number: PCT/US2005/041468
(87) International publication number: WO 2006/062706

(56) References cited:
- EP-A- 1 435 679
- US-A- 5 397 862
- US-B1- 6 379 157

## Description

### Field of the Invention

The present invention relates generally to communication connectors and more particularly to the improvement of return loss in high frequency communication connectors.

### Background of the Invention

In an electrical communication system, it is sometimes advantageous to transmit information signals (video, audio, data) over a pair of wires (hereinafter "wire-pair" or "differential pair") rather than a single wire, wherein the transmitted signal comprises the voltage difference between the wires without regard to the absolute voltages present. Each wire in a wire-pair is susceptible to picking up electrical noise from sources such as lightning, automobile spark plugs and radio stations to name but a few. Because this type of noise is common to both wires within a pair, the differential signal is typically not disturbed. This is a fundamental reason for having closely spaced differential pairs.

Of greater concern, however, is the electrical noise that is picked up from nearby wires or pairs of wires that may extend in the same general direction for some distances and not cancel differentially on the victim pair. This is referred to as crosstalk. Particularly, in a communication system involving networked computers, channels are formed by cascading plugs, jacks and cable segments. In such channels, a modular plug often mates with a modular jack, and the routing of the electrical wires (conductors) within the jack and/or plug also can produce near-end crosstalk (NEXT) (i.e.; the crosstalk measured at an input location corresponding to a source at the same location). This crosstalk occurs from closely-positioned wires over a short distance. In all of the above situations, undesirable signals are present on the electrical conductors that can interfere with the information signal. As long as the same noise signal is added to each wire in the wire-pair, the voltage difference between the wires will remain about the same and differential cross-talk does not exist.

U.S. Pat. No. 5,997,358 to Adriaenssens et al. (hereinafter "the '358 patent") describes a two-stage scheme for compensating differential to differential NEXT for a plug-jack combination. Connectors described in the '358 patent can reduce the internal NEXT (original crosstalk) between the electrical wire pairs of a modular plug by adding a fabricated or artificial crosstalk, usually in the jack, at one or more stages, thereby canceling or reducing the overall crosstalk for the plug-jack combination. The fabricated crosstalk is referred to herein as a compensation crosstalk. This idea can often be implemented by twice crossing the path of one of the differential pairs within the connector relative to the path of another differential pair within the connector, thereby providing two stages of NEXT compensation. This scheme can be more efficient at reducing the NEXT than a scheme in which the compensation is added at a single stage, especially when the second and subsequent stages of compensation include a time delay that is selected to account for differences in phase between the offending and compensating crosstalk. This type of arrangement can include capacitive and/or inductive elements that introduce multi-stage crosstalk compensation, and is typically employed in jack lead frames and PWB structures within jacks. These configurations can allow connectors to meet "Category 6" performance standards set forth in ANSI/EIA/TIA 568, which are primary component standards for mated plugs and jacks for transmission frequencies up to 250MHz.

Unfortunately, the introduction of compensatory crosstalk can negatively impact other electrical properties. For example, "return loss" measures the degree to which the input impedance of a plug-jack combination or an unshielded twisted wire pair (UTP) matches 100 ohms. Achieving acceptable return loss performance, particularly on conductor pairs 1 and 3 (as designated in TIA 568B) of an eight conductor jack, can be especially challenging due to the heavy crosstalk compensation typically required by these two pairs. Pair 1 return loss can be further aggravated by high capacitance shunting resulting from the close proximity of its two contact blades i.e., its "tip" and "ring") in a plug. Reaching an acceptable compromise between crosstalk compensation and return loss can be exceptionally challenging for plugs that are to meet or exceed Category 6 performance parameters, particularly if data transmission speeds of 10 Gb/s over UTP are desired over a frequency range of 1-500 MHz.

European Patent Application No. 1 435 679 A ("the '679 application"). filed November 27. 2003, discloses a modular jack assembly that includes four differential pairs of conductors. The modular jack of the '679 application includes a printed circuit board which has conductive traces thereon that electrically connect eight plug interface contacts to respective ones of eight insulation displacement contacts. As shown in FIG. 6 of the '679 application, portions of the two conductive traces of one of the differential pairs run immediately adjacent to each other such that the signals carried on these conductors will have the same instantaneous current direction.

### Summary of the Invention

The present invention can address some of the issues raised by prior art connectors. As a first aspect, embodiments of the present invention are directed to a communications connector that includes, a first conductive path electrically connecting a first input of the connector and a first output of the connector and a second conductive path electrically connecting a second input of the connector and a second output of the connector, where the first and second conductive paths comprise a first differential pair of conductive paths for transmitting a first information signal. The connector further includes a third conductive path electrically connecting a third input of the connector and a third output of the connector and a fourth conductive path electrically connecting a fourth input of the connector and a fourth output of the connector, wherein the third and fourth conductive paths comprise a second differential pair of conductive paths for transmitting a second information signal. A first section of the first conductive path is immediately adjacent to a first section of the second conductive path that has the same instantaneous current direction as the first section of the first conductive path, and a first section of the third conductive path is immediately adjacent to a first section of the fourth conductive path that has the same instantaneous current direction as the first section of the third conductive path.

### Brief Description of the Figures

**Figure 1** is an exploded perspective view of a communications jack according to embodiments of the present invention.
**Figure 1A** is an enlarged perspective view of a wiring board of the communications jack of **Figure 1****.**
**Figure 2** is a schematic plan view of a wiring board of the jack of Figure 1, with conductors residing on different layers of the wiring board being shown in different shading and/or cross-hatching.
**Figure 3** is an enlarged plan view of a conductor pair of the wiring board of Figure 2.
**Figure 4** is a graph plotting return loss as a function of frequency for conventional and experimental jacks.

### Detailed Description of Embodiments of the Invention

The present invention will be described more particularly hereinafter with reference to the accompanying drawings. The invention is not intended to be limited to the illustrated embodiments; rather, these embodiments are intended to fully and completely disclose the invention to those skilled in this art. In the drawings, like numbers refer to like elements throughout. Thicknesses and dimensions of some components may be exaggerated for clarity.

Unless otherwise defined, all technical and scientific terms used herein have the same meaning as commonly understood by one of ordinary skill in the art to which this invention belongs. The terminology used in the description of the invention herein is for the purpose of describing particular embodiments only and is not intended to be limiting of the invention. As used in the description of the invention and the appended claims, the singular forms "a", "an" and "the" are intended to include the plural forms as well, unless the context clearly indicates otherwise. As used herein, the term "and/or" includes any and all combinations of one or more of the associated listed items. Where used, the terms "attached", "connected", "interconnected", "contacting", "mounted" and the like can mean either direct or indirect attachment or contact between elements, unless stated otherwise. Also, where used, the terms "coupled", "induced" and the like can mean nonconductive electrical interaction, either direct or indirect, between elements or different sections of the same element, unless otherwise stated. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

In addition, spatially relative terms, such as "under", "below", "lower", "over", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is inverted, elements described as "under" or "beneath" other elements or features would then be oriented "over" the other elements or features. Thus, the exemplary term "under" can encompass both an orientation of over and under. The device may be otherwise oriented (rotated 90 degrees or at other orientations) and the spatially relative descriptors used herein interpreted accordingly.

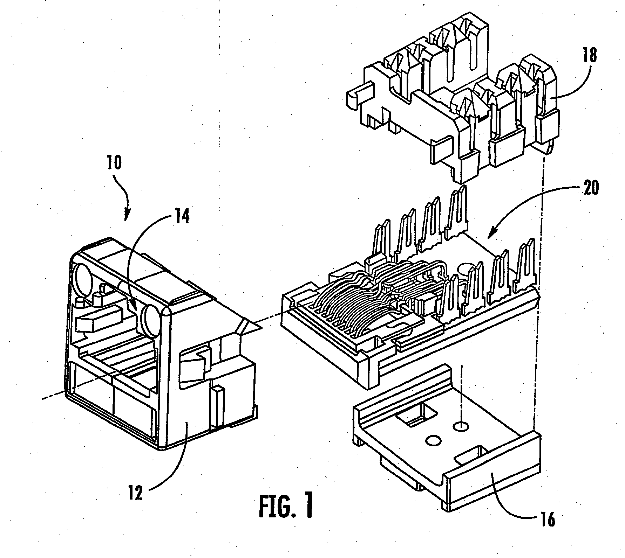

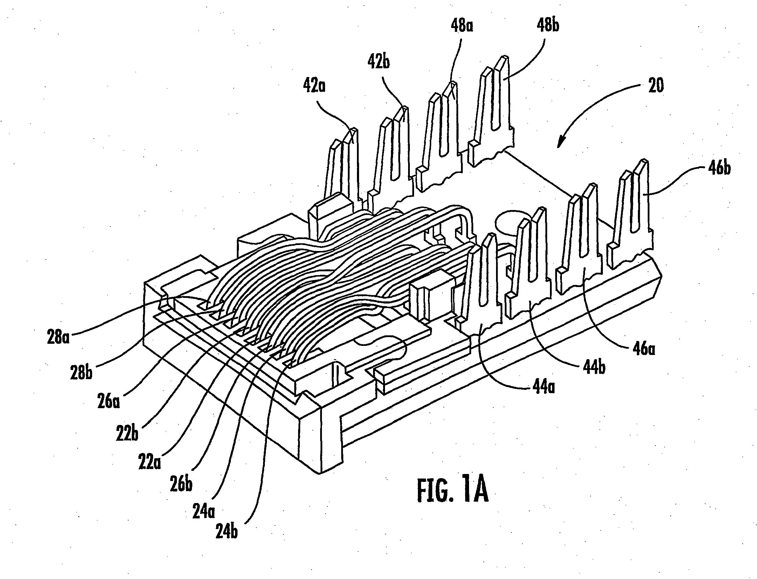

Referring now to the figures, an exemplary communications jack, designated broadly at **10,** is illustrated in **Figure 1****.** The illustrated jack **10** is of the configuration known in this art as an RJ11- or RJ45-style jack. The jack **10** includes a jack frame **12** having a plug aperture **14** for receiving a mating plug (not shown - exemplary plugs are illustrated in U.S. Patent No. 6,250,949 to Lin and in co-pending and co-assigned U.S. Patent Application Serial No. 11/051,305, filed February 4, 2005 and entitled COMMUNICATION PLUG WITH BALANCED WIRING TO REDUCE DIFFERENTIAL TO COMMON MODE CROSSTALK), a cover **16** and a terminal housing **18**. These components are conventionally formed and not need be described in detail herein; for a further description of these components and the manner in which they interconnect, see U.S. Patent No. 6,350,158 to Arnett et al. Those skilled in this art will recognize that other configurations of jack frames, covers and terminal housings may also be employed with the present invention. Exemplary configurations are illustrated in U.S. Patent Nos. 5,975,919 and 5,947,772 to Arnett et al. and U.S. Patent No. 6,464,541 to Hashim et al.

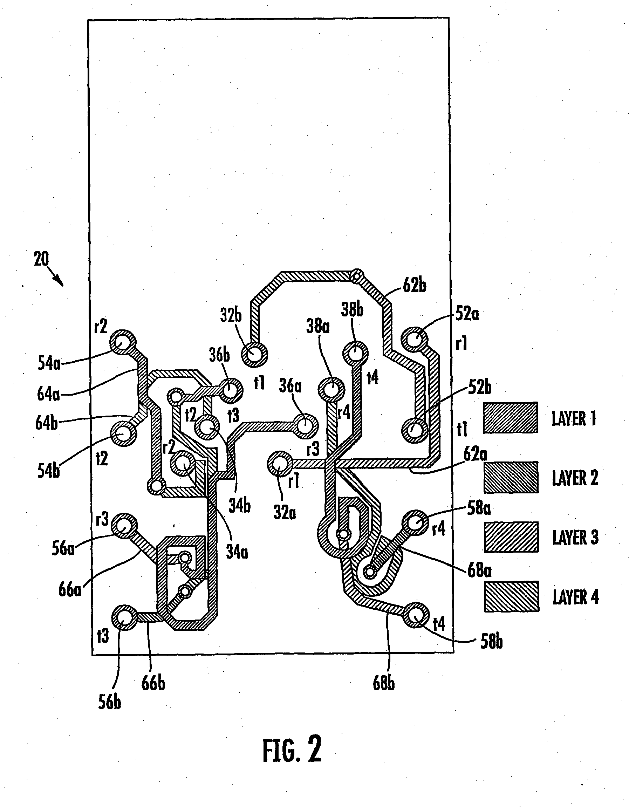

Referring still to **Figure 1** and also to **Figures 1A** and **2****,** the jack **10** further includes a wiring board **20** formed of conventional materials. The wiring board **20** may be a single layer board or, as illustrated, may have multiple layers. The wiring board **20** may be substantially planar as illustrated, or may be non-planar.

Contact wires **22a, 22b, 24a, 24b, 26a, 26b, 28a, 28b** are attached to the wiring board **20.** As described in U.S. Patent No. 6,350,158 referenced above, the contact wires **22a, 22b, 24a, 24b, 26a, 26b, 28a, 28b** have free ends that are disposed generally parallel to each other and that extend into the plug aperture **14** of jack frame **12** to form electrical contact with the terminal blades of a mating plug. The contact wires **22a, 22b, 24a, 24b, 26a, 26b, 28a, 28b** are arranged in pairs defined by TIA 568B, with wires **22a, 22b** (pair 1) being adjacent to each other and in the center of the sequence of wires, wires **24a, 24b** (pair 2) being adjacent to each other and occupying the leftmost two positions (from the vantage point looking from the rear of the jack **10** toward a mating plug in the plug aperture **14)** in the sequence, wires **28a, 28b** (pair 4) being adjacent to each other and occupying the rightmost two positions (again, from the same vantage point as just discussed above) in the sequence, and wires **26a, 26b** (pair 3) being positioned between, respectively, pairs 1 and 4 and pairs 1 and 2. The wires 22a, **22b, 24a, 24b, 26a, 26b, 28a, 28b** are mounted to the wiring board **20** via insertion into respective apertures **32a, 32b, 34a, 34b, 36a, 36b, 38a, 38b,** which are arranged in the illustrated embodiment in a "dual diagonal" pattern as described in U.S. Patent No. 6,196,880 to Goodrich et al. In the illustrated embodiment, the wires **22a, 22b, 24a, 24b, 28a, 28b** of pairs 1, 2 and 4 each include a "crossover", in which the wires of the pair cross each other on a non-contacting fashion between their free and fixed ends.

Those skilled in this art will appreciate that contact wires or other contacts of other configurations may be used. As one example, contact wires configured as described in aforementioned U.S. Patent No. 5,975,919 to Arnett et al. may be employed. As another example, other crossover arrangements may be employed, including those in which only the pair 3 wires include a crossover (see, e.g., co-assigned and co-pending U.S. Patent Application No. 11/044,088, filed March 23, 2005), and those in which pair 3 includes two or more crossovers and pairs 1, 2 and 4 include a crossover (see, e.g., U.S. Patent Application No. 11/208,980, filed August 22, 2005 and entitled *Communications Connector for Imparting Crosstalk Compensation Between Conductors.* Moreover, crossover techniques for the contact wires such as those illustrated and described in co-pending and co-assigned U.S. Patent Application Serial No. 11/139,768, filed May 27, 2005 (Attorney Docket No. 9457-44) may also be employed. The skilled artisan will recognize other suitable alternative configurations. Also, the contact wires may mount on the wiring board in a different configuration, such as the staggered configuration described and illustrated in U.S. Patent Application Serial No. 11/208.980, filed August 22, 2005, entitled *Communications Connector for Imparting Crosstalk Compensation Between Conductors*.

Eight insulation displacement connectors (IDCs) **42a, 42b, 44a, 44b, 46a, 46b, 48a, 48b** are inserted into eight respective IDC apertures **52a, 52b, 54a, 54b, 56a, 56b, 58a, 58b.** The IDCs may be of conventional construction and need not be described in detail herein; exemplary IDCs are illustrated and described in aforementioned U.S. Patent No. 5,975,919 to Arnett. Connectors other than IDCs may also be employed.

Referring now to **Figure 2****,** the each of the wire apertures **32a, 32b, 34a, 34b, 36a, 36b, 38a, 38b** is electrically connected to a respective IDC aperture **52a, 52b, 54a, 54b, 56a, 56b, 58a, 58b** via a respective conductor **62a, 62b, 64a, 64b, 66a, 66b, 68a, 68b,** thereby interconnecting each of the contact wires **22a, 22b, 24a, 24b, 26a, 26b, 28a, 28b** to its corresponding IDC 42a, **42b, 44a, 44b, 46a, 46b, 48a, 48b.** The conductors **62a, 62b, 64a, 64b, 66a, 66b, 68a, 68b** are formed of conventional conductive materials and are deposited on the wiring board **20** via any deposition method known to those skilled in this art to be suitable for the application of conductors. Some conductors are illustrated as being entirely present on a single layer of the wiring board **20** (for example, conductor **62a**)**,** while other conductors (for example, conductor **62b**) may reside on multiple layers of the wiring board **20;** conductors can travel between layers through the inclusion of vias (also known as plated through holes) or other layer-transferring structures known to those skilled in this art.

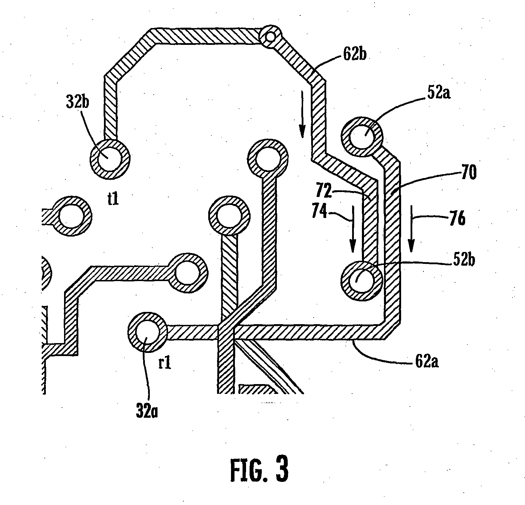

Referring now to **Figure 3****,** it can be seen that conductor **62a,** which connects contact wire **22a** to IDC **42a** i.e., it connects the "ring" of pair 1), and conductor **62b,** which connects contact wire **22b** to IDC **42b** (thereby connecting the "tip" of pair 1), include respective sections **70, 72** that are immediately adjacent each other and that, in this embodiment, follow substantially parallel paths. It can also be seen via the arrows **74, 76** that the polarity of the instantaneous current (and, thus the signal) of the sections **70, 72** is the same. The immediate adjacency of this arrangement results in coupling between the sections **70**and **72** of the conductors **62a, 62b,** thus causing an increase in localized inductance.

It has been determined that judicious selection of the sites where portions of a conductor are positioned immediately adjacent to each other, in the above-described manner, can control the input impedance, and in turn the return loss, of a mated plug-jack combination. As such, the jack **10** can withstand the increased crosstalk compensation that may be necessary to achieve, in a mated plug-jack combination, elevated frequency signal transmission while still experiencing acceptable levels of return loss. Typically, the two coupling sections of the conductors that comprise pair 1 are immediately adjacent to each other for a distance of between about 1.27 to 5.08 millimeters (0.05 and 0.2 inches), although this distance may vary. The gap between the immediately adjacent sections may be between about 0.127 to 0.508 millimeters (5 to 20 mils); in some embodiments, a minimum gap between adjacent conductors of at least 8 mils is preferred. In a typical jack, causing an increase of between about 2 to 8 nanohenries in localized inductance in pair 1 can provide the desired improvement in return loss (the expected level of inductance can be calculated using, for example, equations set forth in H. Greenhouse, Design of Planar Rectangular Microelectric Inductors, IEEE Transactions on Parts, Hybrids, and Packaging, Vol. PHP-10, No. 2 (June 1974) at page 103).

This concept may be applied in conjunction with self-coupling segments within the same conductor to reduce return loss, as described in co-assigned and co-pending U.S. Patent Application Serial No. 11/051,285, filed February 4, 2005.

Typically, and as illustrated, the inclusion of coupling sections in the two conductors that comprise pair 1 is sufficient for improving the return loss performance of those pairs; however, this concept can be applied to other pairs of conductors, such as to any or all of pairs 2, 3 and 4, or to other conductors of jacks that employ different numbers of conductors (e.g., a sixteen conductor jack). Also, although in the illustrated embodiment both of the coupling conductors of a wire pair are mounted on the same layer of the wire board, this need not be the case; one or more layers of a wire board may separate the coupling sections of the conductors. Moreover, the skilled artisan will recognize that many different conductor paths that utilize the concepts of the present invention may be employed.

Those skilled in this art will recognize that embodiments of the wiring board described above may be employed in other environments in which a communications jack may be found. For example, jacks within a patch panel or series of patch panels may be suitable for use with such wiring boards. Other environments may also be possible.

Those skilled in this art will further recognize that the conductor coupling sections described above can be implemented, with similar beneficial effect on return loss, by forming the conductor leads of jacks utilizing metallic leadframe structures instead of printed wiring boards to achieve the required connectivity and crosstalk compensation. In such a configuration, the contact wires and/or the insulation displacement connectors may be formed integrally with the conductors as unitary members.

The invention will now be described in greater detail in the following non-limiting example.

### EXAMPLE

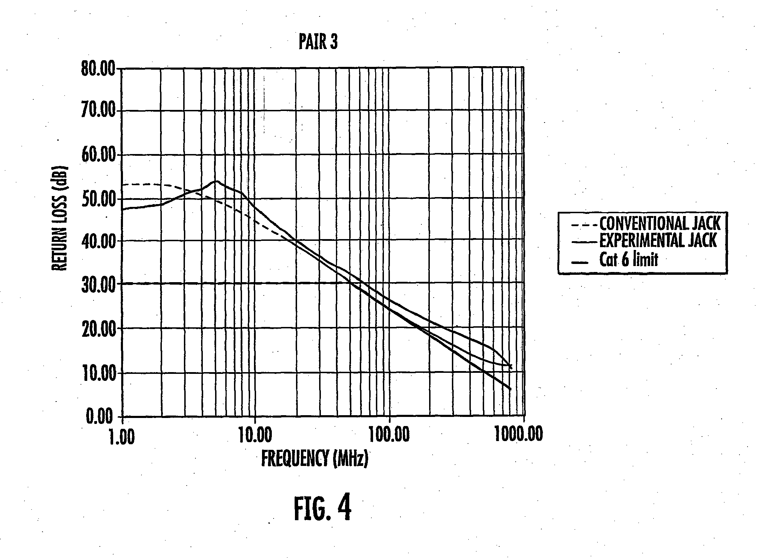

Communications jacks of the configuration illustrated in Figure 1 were constructed. In one set of jacks (labeled "experimental jacks" in Figure 4), the wiring board included conductors of pair 1 that had coupling sections substantially matching those illustrated in Figures 2 and 3. In a second set of jacks (labeled "conventional jacks" in Figure 4), the wiring board included conductors that did not have such coupling sections. The jacks were then tested for return loss on pair 1 under the conditions set forth in TIA/EIA-568-B.2-1 Annex E.

Results of the testing are shown in **Figure 4****.** It can be seen that the experimental jack employing the coupling sections exhibited a significant increase in the return loss decibel level i.e., an improvement) over the conventional jack, at frequencies above about 2.5 MHz.

The foregoing is illustrative of the present invention and is not to be construed as limiting thereof. Although exemplary embodiments of this invention have been described, those skilled in the art will readily appreciate that many modifications are possible in the exemplary embodiments without materially departing from the novel teachings and advantages of this invention. Accordingly, all such modifications are intended to be included within the scope of this invention as defined in the claims. The invention is defined by the following claims.

## Claims

1. A communications connector (10), comprising:
a first conductive path (62a) electrically connecting a first input (22a) of the connector (10) and a first output (42a) of the connector (10);
a second conductive path (62b) electrically connecting a second input (22b) of the connector (10) and a second output (42b) of the connector (10), wherein the first and second conductive paths (62a, 62b) comprise a first differential pair of conductive paths (62a, 62b) for transmitting a first information signal;
a third conductive path (68a) electrically connecting a third input (28a) of the connector (10) and a third output (48a) of the connector (10); and
a fourth conductive path (68b) electrically connecting a fourth input (28b) of the connector (10) and a fourth output (48b) of the connector (10),
wherein the third and fourth conductive paths (68a, 68b) comprise a second differential pair of conductive paths (68a, 68b) for transmitting a second information signal, wherein
a first section (70) of the first conductive path (62a) is immediately adjacent to a first section (72) of the second conductive path (62b) that has the same instantaneous current direction as the first section (70) of the first conductive path (62a), and
a first section of the third conductive path (68a) is immediately adjacent to a first section of the fourth conductive path (68b)
**characterized in that**:
the first section of the fourth conductive path has the same instantaneous current direction as the first section of the third conductive path (68a).

2. The connector (10) defined in Claim 1, wherein the first input (22a) and the second input (22b) are between the third input (26a) and the fourth input (26b).

3. The connector (10) defined in Claim 1, wherein the first section (70) of the first conductive path (62a) and the first section (72) of the second conductive path (62b) have substantially the same instantaneous current direction for 1.27 to 5.08 millimeters.

4. The connector (10) defined in Claim 3, wherein a gap between the first section (70) of the first conductive path 62a and the first section (72) of the second conductive path (62b) is between 0.203 and 0.381 millimeters.

5. The connector (10) defined in Claim 4, wherein the localized increase in inductance is between 2 and 8 nanohenries.

6. The connector (10) defined in Claim 1, wherein the first section (70) of the first conductive path (62a) and the first section (72) of the second conductive path (62b) are adjacent at least one of the first output (42a) or the second output (42b).

7. The connector (10) defined in Claim 1, wherein the first input (22a) and the second input (22b) are directly adjacent to each other.

8. The connector (10) defined in Claim 2, the connector (10) further comprising a dielectric mounting substrate (20) having first and second contact wire mounting locations (32a, 32b) and first and second output terminal mounting locations (52a, 52b), wherein the first conductive path (62a) comprises one or more first conductive traces on the dielectric mounting substrate (20) electrically connecting the first contact wire mounting location (32a) to the first output terminal mounting location (52a), and wherein the second conductive path (62b) comprises one or more second conductive traces on the dielectric mounting substrate (20) electrically connecting the second contact wire mounting location (32b) to the second output terminal mounting location (52b).

9. The connector (10) defined in Claim 8, wherein the first section (70) of the first conductive path (62a) comprises at least a portion of one of the one or more first conductive traces on the dielectric mounting substrate (20) and wherein the first section of the second conductive path (62b) comprises at least a portion of one of the one or more second conductive traces on the dielectric mounting substrate (20).

## Patentansprüche

1. Kommunikationsanschlussbuchse (10), Folgendes aufweisend:
eine erste Leiterbahn (62a), die einen ersten Eingang (22a) der Anschlussbuchse (10) und einen ersten Ausgang (42a) der Anschlussbuchse (10) elektrisch verbindet;
eine zweite Leiterbahn (62b), die einen zweiten Eingang (22b) der Anschluss-buchse (10) und einen zweiten Ausgang (42b) der Anschlussbuchse (10) elektrisch verbindet, wobei die erste und zweite Leiterbahn (62a, 62b) ein erstes differentielles Paar von Leiterbahnen (62a, 62b) zur Übertragung eines ersten Informationssignals umfassen;
eine dritte Leiterbahn (68a), die einen dritten Eingang (28a) der Anschlussbuchse (10) und einen dritten Ausgang (48a) der Anschlussbuchse (10) elektrisch verbindet; und
eine vierte Leiterbahn (68b), die einen vierten Eingang (28b) der Anschlussbuchse (10) und einen vierten Ausgang (48b) der Anschlussbuchse (10) elektrisch verbindet, wobei die dritte und vierte Leiterbahn (68a, 68b) ein zweites differentielles Paar von Leiterbahnen (68a, 68b) zur Übertragung eines zweiten Informationssignals umfassen, wobei
ein erster Abschnitt (70) der ersten Leiterbahn (62a) unmittelbar an einen ersten Abschnitt (72) der zweiten Leiterbahn (62b) angrenzt, der dieselbe Momentanstromrichtung hat wie der erste Abschnitt (70) der ersten Leiterbahn (62a), und
ein erster Abschnitt der dritten Leiterbahn (68a) unmittelbar an einen ersten Abschnitt der vierten Leiterbahn (68b) angrenzt,
**dadurch gekennzeichnet, dass**
der erste Abschnitt der vierten Leiterbahn dieselbe Momentanstromrichtung hat wie der erste Abschnitt der dritten Leiterbahn (68a).

2. Anschlussbuchse (10) nach Anspruch 1, wobei sich der erste Eingang (22a) und der zweite Eingang (22b) zwischen dem dritten Eingang (26a) und dem vierten Eingang (26b) befinden.

3. Anschlussbuchse (10) nach Anspruch 1, wobei der erste Abschnitt (70) der ersten Leiterbahn (62a) und der erste Abschnitt (72) der zweiten Leiterbahn (62b) über 1,27 bis 5,08 Millimeter im Wesentlichen dieselbe Momentanstromrichtung haben.

4. Anschlussbuchse (10) nach Anspruch 3, wobei ein Zwischenraum zwischen dem ersten Abschnitt (70) der ersten Leiterbahn (62a) und dem ersten Abschnitt (72) der zweiten Leiterbahn (62b) zwischen 0,203 und 0,381 Millimeter beträgt.

5. Anschlussbuchse (10) nach Anspruch 4, wobei der lokale Induktanzanstieg zwischen 2 und 8 Nanohenry beträgt.

6. Anschlussbuchse (10) nach Anspruch 1, wobei der erste Abschnitt (70) der ersten Leiterbahn (62a) und der erste Abschnitt (72) der zweiten Leiterbahn (62b) an den ersten Ausgang (42a) und/oder den zweiten Ausgang (42b) angrenzen.

7. Anschlussbuchse (10) nach Anspruch 1, wobei der erste Eingang (22a) und der zweite Eingang (22b) direkt aneinander angrenzen.

8. Anschlussbuchse (10) nach Anspruch 2, wobei die Anschlussbuchse (10) darüber hinaus ein dielektrisches Montagesubstrat (20) mit einer ersten und zweiten Kontaktdrahtmontagestelle (32a, 32b) und einer ersten und zweiten Ausgangsanschlussmontagestelle (52a, 52b) umfasst, wobei die erste Leiterbahn (62a) eine oder mehrere erste Leiterspur/en auf dem dielektrischen Montagesubstrat (20) aufweist, welche die erste Kontaktdrahtmontagestelle (32a) elektrisch mit der ersten Ausgangsanschlussmontagestelle (52a) verbindet/verbinden, und wobei die zweite Leiterbahn (62b) eine oder mehrere zweite Leiterspur/en auf dem dielektrischen Montagesubstrat (20) aufweist, welche die zweite Kontaktdrahtmontagestelle (32b) elektrisch mit der zweiten Ausgangsanschlussmontagestelle (52b) verbindet/verbinden.

9. Anschlussbuchse (10) nach Anspruch 8, wobei der erste Abschnitt (70) der ersten Leiterbahn (62a) zumindest einen Teil einer der einen oder mehreren ersten Leiterspur/en auf dem dielektrischen Montagesubstrat (20) umfasst, und wobei der erste Abschnitt der zweiten Leiterbahn (62b) zumindest einen Teil einer der einen oder mehreren zweiten Leiterspur/en auf dem dielektrischen Montagesubstrat (20) umfasst.

## Revendications

1. Connecteur de communications (10) comprenant :
un premier chemin conducteur (62a) qui connecte électriquement une première entrée (22a) du connecteur (10) et une première sortie (42a) du connecteur (10) ;
un deuxième chemin conducteur (62b) qui connecte électriquement une deuxième entrée (22b) du connecteur (10) et une deuxième sortie (42b) du connecteur (10), dans lequel les premier et deuxième chemins conducteurs (62a, 62b) comprennent une première paire différentielle de chemins conducteurs (62a, 62b) destinés à transmettre un premier signal d'informations ;
un troisième chemin conducteur (68a) qui connecte électriquement une troisième entrée (28a) du connecteur (10) et une troisième sortie (48a) du connecteur (10) ; et
un quatrième chemin conducteur (68b) qui connecte électriquement une quatrième entrée (28b) du connecteur (10) et une quatrième sortie (48b) du connecteur (10), dans lequel les troisième et quatrième chemins conducteurs (68a, 68b) comprennent une deuxième paire différentielle de chemins conducteurs (68a, 68b) destinés à transmettre un deuxième signal d'informations ; dans lequel
une première section (70) du premier chemin conducteur (62a) est immédiatement adjacente à une première section (72) du deuxième chemin conducteur (62b) qui présente la même direction de courant instantané que la première section (70) du premier chemin conducteur (62a) ; et
une première section du troisième chemin conducteur (68a) est immédiatement adjacente à une première section du quatrième chemin conducteur (68b) ;
**caractérisé en ce que** :
la première section du quatrième chemin conducteur présente la même direction de courant instantané que la première section du troisième chemin conducteur (68a).

2. Connecteur (10) selon la revendication 1, dans lequel la première entrée (22a) et la deuxième entrée (22b) sont entre la troisième entrée (26a) et la quatrième entrée (26b).

3. Connecteur (10) selon la revendication 1, dans lequel la première section (70) du premier chemin conducteur (62a) et la première section (72) du deuxième chemin conducteur (62b) présentent sensiblement la même direction de courant instantané sur une distance comprise entre 1,27 millimètres et 5,08 millimètres.

4. Connecteur (10) selon la revendication 3, dans lequel un espace entre la première section (70) du premier chemin conducteur (62a) et la première section (72) du deuxième chemin conducteur (62b), est compris entre 0,203 millimètres et 0,381 millimètres.

5. Connecteur (10) selon la revendication 4, dans lequel l'augmentation localisée de l'inductance est comprise entre 2 nanohenrys et 8 nanohenrys.

6. Connecteur (10) selon la revendication 1, dans lequel la première section (70) du premier chemin conducteur (62a) et la première section (72) du deuxième chemin conducteur (62b) sont adjacentes à l'une au moins de la première sortie (42a) ou de la deuxième sortie (42b).

7. Connecteur (10) selon la revendication 1, dans lequel la première entrée (22a) et la deuxième entrée (22b) sont directement adjacentes l'une à l'autre.

8. Connecteur (10) selon la revendication 2, le connecteur (10) comprenant en outre un substrat de montage diélectrique (20) présentant des premier et deuxième emplacements de montage de fil de contact (32a, 32b) et des premier et deuxième emplacements de montage de borne de sortie (52a, 52b), dans lequel le premier chemin conducteur (62a) comprend une ou plusieurs premières pistes conductrices sur le substrat de montage diélectrique (20) qui connectent électriquement le premier emplacement de montage de fil de contact (32a) au premier emplacement de montage de borne de sortie (52a), et dans lequel le deuxième chemin conducteur (62b) comprend une ou plusieurs deuxièmes pistes conductrices sur le substrat de montage diélectrique (20) qui connectent électriquement le deuxième emplacement de montage de fil de contact (32b) au deuxième emplacement de montage de borne de sortie (52b).

9. Connecteur (10) selon la revendication 8, dans lequel la première section (70) du premier chemin conducteur (62a) comprend une partie au moins d'une ou de plusieurs premières pistes conductrices sur le substrat de montage diélectrique (20), et dans lequel la première section du deuxième chemin conducteur (62b) comprend une partie au moins d'une ou de plusieurs deuxièmes pistes conductrices sur le substrat de montage diélectrique (20).
